(19) Europäisches Patentamt
European Patent Office
Office européen des brevets

(11) **EP 4 636 415 A1**

(12) **EUROPEAN PATENT APPLICATION**
published in accordance with Art. 153(4) EPC

(43) Date of publication:
**22.10.2025 Bulletin 2025/43**

(21) Application number: 24757125.0

(22) Date of filing: **07.02.2024**

(51) International Patent Classification (IPC):
*G01R 31/327* (2006.01)  *G01R 19/165* (2006.01)
*G01R 31/385* (2019.01)  *G01R 27/02* (2006.01)
*G08C 17/02* (2006.01)

(52) Cooperative Patent Classification (CPC):
**G01R 19/165; G01R 27/02; G01R 31/327;
G01R 31/385; G08C 17/02**

(86) International application number:
**PCT/KR2024/001852**

(87) International publication number:
**WO 2024/172396 (22.08.2024 Gazette 2024/34)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.02.2023 KR 20230019003**

(71) Applicant: **LG Energy Solution, Ltd.
Seoul 07335 (KR)**

(72) Inventors:
• **HWANG, Jin-Woo
Daejeon 34122 (KR)**
• **KIM, Duk-Su
Daejeon 34122 (KR)**

(74) Representative: **Plasseraud IP
104 Rue de Richelieu
CS92104
75080 Paris Cedex 02 (FR)**

(54) **BATTERY MANAGEMENT APPARATUS HAVING SWITCH FAILURE DIAGNOSIS FUNCTION,
AND SYSTEM AND METHOD COMPRISING SAME**

(57)    Disclosed is a battery managing apparatus having a switch failure diagnosing function, and a system and method including the same. The battery managing apparatus includes a main switch installed on a first line connected to one terminal of a battery; a precharge circuit including a first precharge resistor, a precharge switch, and a second precharge resistor sequentially connected in series, and connected in parallel with both ends of the main switch; a current measuring unit configured to measure current flowing through a second line connected to the other terminal of the battery; a diagnosing switch installed on a branch line that connects one end of the precharge switch and the second line; and a control unit operably coupled with the main switch, the precharge switch, the diagnosing switch and the current measuring unit. The control unit may be configured to receive a diagnosing current value from the current measuring unit when the diagnosing switch is turned on or off, and diagnose whether at least one of the main switch and the precharge switch has a fusion failure depending on the magnitude of the diagnosing current value.

FIG. 1

**Description**

TECHNICAL FIELD

The present disclosure relates to a battery managing apparatus having a switch failure diagnosing function, and a system and method including the same, and more specifically, to a battery managing apparatus capable of reliably diagnosing a fusion failure of a main switch and a precharge switch installed on a line that connects a battery and a load, and a system and method including the same.

The present application claims priority to Korean Patent Application No. 10-2023-0019003 filed on February 13, 2023 in the Republic of Korea, the disclosures of which are incorporated herein by reference.

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries have advantages in that they have almost no memory effect compared to nickel-based batteries and also have very low self-charging rate and high energy density.

The battery includes a plurality of cells. The plurality of cells may be connected in series and/or parallel depending on the operation voltage of the load. The load may be a power consumption device including a power converter such as an inverter or a charging device that provides a charging current to the battery.

A power line connecting the battery and the load includes a precharge circuit. The precharge circuit is connected in parallel with the main switch of the power line. The precharge circuit includes a precharge resistor and a precharge switch.

When the battery and the load are connected, the precharge switch is turned on first before the main switch is turned on. Then, the capacitor is charged as current flows from the battery through the precharge resistor to the capacitor included in the input terminal of the load. The magnitude of the charging current of the capacitor gradually increases. The charging time of the capacitor depends on the time constant determined by the resistance of the precharge resistor and the capacitance of the capacitor. When the capacitor is fully or sufficiently charged, the precharge switch is turned off and the main switch is turned on. If the main switch is turned on after the capacitor is charged, the phenomenon of inrush current flowing from the high-voltage battery to the load may be prevented. For reference, inrush current may damage circuit components included in the load or cause an electric shock.

Meanwhile, if a fusion failure occurs in the main switch, there is a problem that inrush current flows to the load through the main switch even if the main switch is controlled to be turned off when the battery and the load are connected. Also, if a fusion failure occurs in the precharge switch, there is a problem that the battery discharge continues through the precharge resistor even if both the main switch and the precharge switch are controlled to be turned off.

Therefore, in the related art, there is a need for technology that may reliably diagnose a fusion failure of the main switch and precharge switch.

As an example of the related technology, there is a technology to measure the voltage difference between the front and rear ends of the main switch before turning on the precharge switch, and diagnose that a fusion failure has occurred in the main switch if the voltage difference is 0. However, this technology has the limitation that it cannot diagnose a fusion failure of the precharge switch.

As another example of the related technology, there is a technology to measure the magnitude of current flowing through the power line after controlling both the main switch and the precharge switch to be turned off, and diagnose that a fusion failure has occurred in the main switch if the magnitude of the current exceeds a threshold. However, even if the main switch is normal and a fusion failure occurs in the precharge switch, current flows through the power line, so the diagnosis of a main switch failure is not accurate.

DISCLOSURE

Technical Problem

The present disclosure is designed to solve the problems of the related art, and therefore the present disclosure is directed to providing a battery managing apparatus, and a system and method including the same, which may reliably diagnose a fusion failure of a main switch installed on a power line that connects a battery and a load and a precharge switch included in a precharge circuit.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

**In** one aspect of the present disclosure, there is provided a battery managing apparatus having a switch failure diagnosing function, comprising: a main switch installed on a first line connected to one terminal of a battery; a precharge circuit including a first precharge resistor, a precharge switch, and a second precharge resistor sequentially connected in series, the precharge circuit being connected in parallel with both ends of the main switch; a current measuring unit configured to measure current flowing through a second line connected to the other terminal of the battery; a diagnosing switch installed on a branch line that connects one end of the precharge switch and the second line; and a control unit operably coupled with the main switch, the precharge switch, the diagnosing switch and the current measuring unit.

The control unit may be configured to receive a diagnosing current value from the current measuring unit when the diagnosing switch is turned on or off, and diagnose whether at least one of the main switch and the precharge switch has a fusion failure depending on the magnitude of the diagnosing current value.

The battery managing apparatus may further comprise a first voltage measuring unit configured to measure a battery voltage between a first terminal and a second terminal of the battery; and a second voltage measuring unit configured to measure a voltage of a load between a first connection terminal and a second connection terminal of the load.

The control unit may be configured to receive the battery voltage and the voltage of the load from the first voltage measuring unit and the second voltage measuring unit, respectively, and receive the diagnosing current value from the current measuring unit, when the main switch and the precharge switch are turned off, and diagnose that there is no fusion failure in the main switch and the precharge switch when a difference between the battery voltage and the voltage of the load is greater than a preset threshold voltage value and the diagnosing current value is substantially 0.

The control unit may be optionally configured to turn on the diagnosing switch and then receive the diagnosing current value from the current measuring unit when the difference between the battery voltage and the voltage of the load is substantially 0 and the diagnosing current value is substantially 0, and diagnose that a fusion failure has occurred in any one of the main switch and the precharge switch when the diagnosing current value is greater than a preset first threshold current value.

The control unit may be optionally configured to diagnose that the main switch and the precharge switch have a fusion failure when the diagnosing current value is greater than a preset second threshold current value, which is greater than the first threshold current value.

**In** one aspect, the first precharge resistor and the second precharge resistor may have a first resistance value and a second resistance value, respectively, where the first resistance value is greater than the second resistance value. Also, the first threshold current value may be divided into a first sub-threshold current value determined by Ohm's law from the first resistance value, a fusion diagnosing resistance of the precharge switch and the battery voltage, and a second sub-threshold current value (greater than the first sub-threshold current value) determined by Ohm's law from the second resistance value, a fusion diagnosing resistance of the main switch and the battery voltage. The control unit may be optionally configured to: diagnose that a fusion failure has occurred in the precharge switch when the diagnosing current value is greater than the first sub-threshold current value and is equal to or smaller than the second sub-threshold current value, diagnose that a fusion failure has occurred in the main switch when the diagnosing current value is greater than the second sub-threshold current value and is equal to or smaller than the second threshold current value, and diagnose that a fusion failure has occurred in both the main switch and the precharge switch when the diagnosing current value is greater than the second threshold current value.

**In** another aspect, the first precharge resistor and the second precharge resistor may have a first resistance value and a second resistance value, respectively, where the second resistance value is greater than the first resistance value. Also, the first threshold current value may be divided into a first sub-threshold current value determined by Ohm's law from the first resistance value, a fusion diagnosing resistance of the precharge switch and the battery voltage, and a second sub-threshold current value (smaller than the first sub-threshold current value) determined by Ohm's law from the second resistance value, a fusion diagnosing resistance of the main switch and the battery voltage. **In** this case, the control unit may be optionally configured to: diagnose that a fusion failure has occurred in the main switch when the diagnosing current value is greater than the second sub-threshold current value and is equal to or smaller than the first sub-threshold current value, diagnose that a fusion failure has occurred in the precharge switch when the diagnosing current value is greater than the first sub-threshold current value and is equal to or smaller than the second threshold current value, and diagnose that a fusion failure has occurred in both the main switch and the precharge switch when the diagnosing current value is greater than the second threshold current value.

The battery managing apparatus may further comprise a storage medium operably coupled with the control unit, and the control unit may be configured to record a failure diagnosing result for the main switch and the precharge switch on the storage medium.

The battery managing apparatus may further comprise an output device operably coupled with the control unit, and the control unit may be configured to read the failure diagnosing result from the storage medium and output the failure diagnosing result visually through the output device.

The battery managing apparatus may further comprise a communication interface operably coupled with the control unit, and the control unit may be configured to read the failure diagnosing result from the storage medium and transmit the failure diagnosing result to the outside through the communication interface.

In another aspect of the present disclosure, there is also provided a system, comprising the battery managing apparatus having at least one of the above features, and a vehicle, comprising the system.

In another aspect of the present disclosure, there is also provided a battery managing method having a switch failure diagnosing function using a main switch installed on a first line connected to one terminal of a battery; a precharge circuit including a first precharge resistor, a precharge switch, and a second precharge resistor sequentially connected in series, the precharge circuit being connected in parallel with both ends of the main switch; a current measuring unit configured to measure current flowing through a second line connected to the other terminal of the battery; and a diagnosing switch installed on a branch line that connects one end of the precharge switch and the second line, the battery managing method comprising: (a) receiving a diagnosing current value from the current measuring unit when the diagnosing switch is turned on or off; and (b) diagnosing whether at least one of the main switch and the precharge switch has a fusion failure depending on the magnitude of the diagnosing current value.

The battery managing method may further comprise: measuring a battery voltage between a first terminal and a second terminal of the battery and a voltage of a load between a first connection terminal and a second connection terminal of the load when the main switch and the precharge switch are turned off.

In the step (b) of the battery managing method, optionally, it may be diagnosed that there is no fusion failure in the main switch and the precharge switch when a difference between the battery voltage and the voltage of the load is greater than a preset threshold voltage value and the diagnosing current value is substantially 0.

In the step (a) of the battery managing method, the diagnosing switch may be turned on and then the diagnosing current value may be received from the current measuring unit when a difference between the battery voltage and the voltage of the load is substantially 0 and the diagnosing current value is substantially 0.

In the step (b), it may be diagnosed that a fusion failure has occurred in any one of the main switch and the precharge switch when the diagnosing current value is greater than a preset first threshold current value.

In the step (b) of the battery managing method, it may be diagnosed that both the main switch and the precharge switch have a fusion failure when the diagnosing current value is greater than a preset second threshold current value, which is greater than the first threshold current value.

In one aspect, the first precharge resistor and the second precharge resistor may have a first resistance value and a second resistance value, respectively, where the first resistance value is greater than the second resistance value. Also, the first threshold current value may be divided into a first sub-threshold current value determined by Ohm's law from the first resistance value, a fusion diagnosing resistance of the precharge switch and the battery voltage, and a second sub-threshold current value (greater than the first sub-threshold current value) determined by Ohm's law from the second resistance value, a fusion diagnosing resistance of the main switch and the battery voltage. In the step (b) of the battery managing method, it may be diagnosed that a fusion failure has occurred in the precharge switch when the diagnosing current value is greater than the first sub-threshold current value and is equal to or smaller than the second sub-threshold current value, it may be diagnosed that a fusion failure has occurred in the main switch when the diagnosing current value is greater than the second sub-threshold current value and is equal to or smaller than the second threshold current value, and it may be diagnosed that a fusion failure has occurred in both the main switch and the precharge switch when the diagnosing current value is greater than the second threshold current value.

In another aspect, the first precharge resistor and the second precharge resistor may have a first resistance value and a second resistance value, respectively, where the second resistance value is greater than the first resistance value. Also, the first threshold current value may be divided into a first sub-threshold current value determined by Ohm's law from the first resistance value, a fusion diagnosing resistance of the precharge switch and the battery voltage, and a second sub-threshold current value (smaller than the first sub-threshold current value) determined by Ohm's law from the second resistance value, a fusion diagnosing resistance of the main switch and the battery voltage. In the step (b) of the battery managing method, it may be diagnosed that a fusion failure has occurred in the main switch when the diagnosing current value is greater than the second sub-threshold current value and is equal to or smaller than the first sub-threshold current value, it may be diagnosed that a fusion failure has occurred in the precharge switch when the diagnosing current value is greater than the first sub-threshold current value and is equal to or smaller than the second threshold current value, and it may be diagnosed that a fusion failure has occurred in both the main switch and the precharge switch when the diagnosing current value is greater than the second threshold current value.

The battery managing method may further comprise: recording a failure diagnosing result for the main switch and the precharge switch on a storage medium.

The battery managing method may further comprise: reading the failure diagnosing result from the storage medium and output the failure diagnosing result visually through an output device.

The battery managing method may further comprise: reading the failure diagnosing result from the storage medium and transmit the failure diagnosing result to the outside through a communication interface.

Advantageous Effects

According to the present disclosure, it is possible to reliably diagnose a fusion failure of the main switch and/or the precharge switch installed on the high potential line of the battery by installing a precharge circuit in which a first precharge resistor, a precharge switch and a second precharge resistor are sequentially connected in series, and a diagnosing switch on a branch line connecting one end of the precharge switch and the low potential line of the battery and analyzing the magnitude of the diagnosing current value measured immediately after the diagnosing switch is turned on.

The effects of the present disclosure are not limited to the effects mentioned above, and other effects not mentioned will be clearly understood by those skilled in the art from the description of the claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a block diagram schematically showing the configuration of a battery managing apparatus having a switch failure diagnosing function according to an embodiment of the present disclosure.

FIG. 2 is a drawing schematically showing current flowing in a branch line ($L_3$) when a fusion failure occurs in a first main switch SW1 installed on a high potential line of a battery and/or a precharge switch ($SW_{FC}$) included in a precharge circuit according to an embodiment of the present disclosure.

FIG. 3 is a flowchart for illustrating a battery managing method having a switch failure diagnosing function according to an embodiment of the present disclosure.

FIG. 4 is a flowchart for illustrating a battery managing method having a switch failure diagnosing function according to another embodiment of the present disclosure.

BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

The terms including the ordinal number such as "first", "second" and the like, are used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise. Also, terms such as <control unit> described in the specification refer to a unit that processes at least one function or operation, and may be implemented as hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

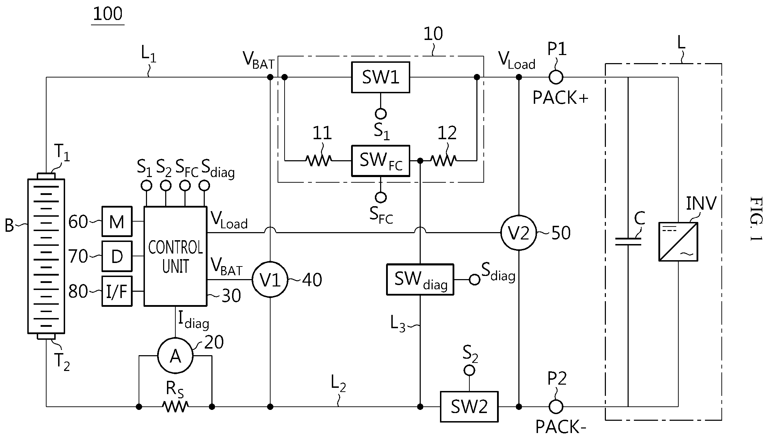

FIG. 1 is a block diagram schematically showing the configuration of a battery managing apparatus 100 having a switch failure diagnosing function according to an embodiment of the present disclosure.

Referring to FIG. 1, the battery managing apparatus 100 is connected between a battery B and a load L. The load L may be a device that consumes energy from the battery B. The load L may include a capacitor C at the input terminal. Also, the load L may include a power converter such as an inverter (INV) that converts direct current supplied from the battery B into alternating current. In a modification, the load L may be a charging device (not shown) that supplies a charging current to the battery B.

The battery managing apparatus 100 may control the electrical connection between the battery B and the load L and diagnose a fusion failure of the switch. The battery managing apparatus 100 may also perform the operations of controlling the charging and discharging of the battery B, measuring the voltage, temperature, and current of the battery B, determining the SOC (State Of Charge) and SOH (State Of Health) of the battery B using the voltage, temperature, and current of the battery B, or protecting the battery B from dangerous situations such as overcharge/overdischarge/overcurrent/short circuit.

The battery managing apparatus 100 may include a first line ($L_1$) and a second line ($L_2$) connecting the battery B and the load L. The first line ($L_1$) and the second line ($L_2$) are power lines through which a charging current or discharging current flows. The first line ($L_1$) is a high voltage line and the second line ($L_2$) is a low voltage line.

The battery managing apparatus 100 may also include a first main switch SW1 and a second main switch SW2 installed on the first line ($L_1$) and the second line ($L_2$), respectively. In a modification, the second main switch SW2 may be omitted.

The battery managing apparatus 100 may also include a precharge circuit 10 having a first precharge resistor 11, a precharge switch ($SW_{FC}$) and a second precharge resistor 12 sequentially connected in series, and the precharge circuit 10 may be connected in parallel with both ends of the first main switch SW1.

The first precharge resistor 11 is installed adjacent to the battery B, and the second precharge resistor 12 is installed adjacent to the load L.

First precharge resistor 11 may have a first resistance value, and the second precharge resistor 12 may have a second resistance value. The first resistance value and the second resistance value may be the same or different.

The battery managing apparatus 100 may include a current measuring unit 20 that measures current flowing through the second line ($L_2$). The current measuring unit 20 may be a known current sensor capable of measuring the magnitude of current. In an embodiment, the current measuring unit 20 may output a voltage value indicating the magnitude of current flowing through a sense resistor ($R_S$) installed on the second line ($L_2$). The voltage value may be converted to a current value by Ohm's law. The current measuring unit 20 may be replaced with a Hall sensor that measures the magnitude of current using the intensity of the magnetic field formed around the second line ($L_2$).

The battery managing apparatus 100 may further include a diagnosing switch ($SW_{diag}$) installed on a branch line ($L_3$) that connects one end of the precharge switch ($SW_{FC}$) and the second line ($L_2$). The branch line ($L_3$) corresponds to a line connected in parallel with the battery B and the load L.

The battery managing apparatus 100 may include a control unit 30 operably coupled with the first main switch SW1, the second main switch SW2, the precharge switch ($SW_{FC}$), the diagnosing switch ($SW_{FC}$), and the current measuring unit 20.

In the drawing, symbol $S_1$ is a voltage signal that controls the first main switch SW1 to turn on or off, symbol $S_2$ is a voltage signal that controls the second main switch SW2 to turn on or off, symbol $S_{FC}$ is a voltage signal that controls the precharge switch ($SW_{FC}$) to turn on or off, and symbol $S_{diag}$ is a voltage signal that controls the diagnosing switch ($SW_{diag}$) to turn on or off.

The control unit 30 may be configured to receive a diagnosing current value ($I_{diag}$) from the current measuring unit 20 when the diagnosing switch ($SW_{diag}$) is turned on or off, and diagnose a fusion failure of at least one of the first main switch SW1 and the precharge switch ($SW_{FC}$) based on the magnitude of the diagnosing current value ($I_{diag}$).

In an embodiment, the first main switch SW1, the second main switch SW2, and the precharge switch ($SW_{FC}$) may be relay switches, and the diagnosing switch ($SW_{diag}$) may be a semiconductor switch such as a MOSFET (Metal Oxide Semiconductor Field Effect Transistor).

The parts that make up the switches (SW1, SW2, $SW_{FC}$, $SW_{diag}$) may be replaced with other mechanical switches or other semiconductor switches known in the art.

The fusion failure of a switch refers to a failure in which the turn-on state of the switch is maintained even if a turn-off control signal is applied to the switch in a turn-on state. In one example, the fusion failure occurs when contacts included in the relay switch become stuck to each other and remain in contact. Sticking of contacts may occur when the contacts are partially melted by excessive current flowing through the switch or arc generated during switch operation.

The battery managing apparatus 100 may further include a first voltage measuring unit 40 that measures a battery voltage ($V_{BAT}$) between the first terminal T1 and the second terminal T2 of the battery B, and a second voltage measuring unit 50 that measures a voltage ($V_{Load}$) of the load between the first connection terminal P1 and the second connection terminal P2 of the load L.

According to one aspect, the control unit 30 may receive the battery voltage ($V_{BAT}$) and the voltage ($V_{Load}$) of the load from the first voltage measuring unit 40 and the second voltage measuring unit 50, respectively, and receive the diagnosing current value ($I_{diag}$) from the current measuring unit 20 when the first main switch SW1, optionally the second main switch SW2, and the precharge switch ($SW_{FC}$) are turned off.

The control unit 30 may also diagnose that there is no fusion failure in the first switch SW1, if the condition that the difference between the battery voltage ($V_{BAT}$) and the voltage ($V_{Load}$) of the load is greater than a preset threshold voltage value ($V_{th}$) and the diagnosing current value ($I_{diag}$) is substantially 0 is met. The threshold voltage value ($V_{th}$) may be set in advance. In one example, the threshold voltage value ($V_{th}$) may be set to a value equal to or greater than 1 volt.

According to another aspect, the control unit 30 may receive the battery voltage ($V_{BAT}$) and the voltage ($V_{Load}$) of the load from the first voltage measuring unit 40 and the second voltage measuring unit 50, respectively, and receive the diagnosing current value ($I_{diag}$) from the current measuring unit 20 when the first main switch SW1, optionally the second main switch SW2, and the precharge switch ($SW_{FC}$) are turned off.

The control unit 30 may also turn on the diagnosing switch ($SW_{diag}$) and then receive the diagnosing current value ($I_{diag}$) from the current measuring unit 20 if the condition that the difference between the battery voltage ($V_{BAT}$) and the voltage ($V_{Load}$) of the load is substantially 0 and the diagnosing current value ($I_{diag}$) is substantially 0 is met.

For reference, if the load L does not operate or the battery B is electrically separated from the load L, the diagnosing current value ($I_{diag}$) may be 0 even if the difference between the battery voltage ($V_{BAT}$) and the voltage ($V_{Load}$) of the load is substantially 0.

The control unit 30 may also diagnose that a fusion failure has occurred in any one of the first main switch SW1 and the precharge switch ($SW_{FC}$) if the condition that the diagnosing current value ($I_{diag}$) is greater than a preset first threshold current value ($I_{th1}$) is met.

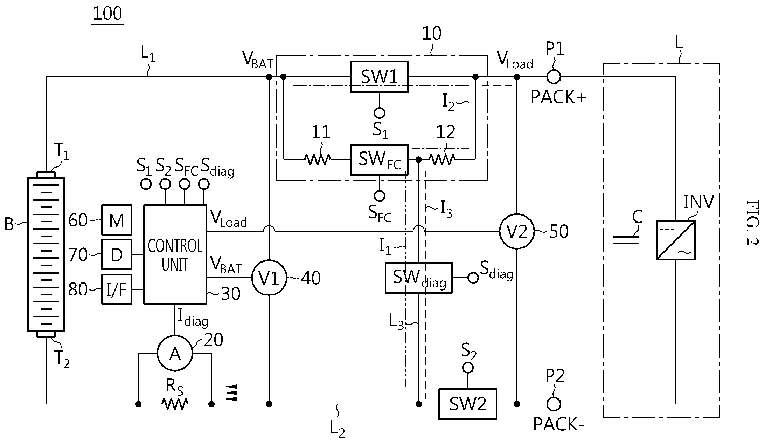

FIG. 2 is a drawing showing current flowing in the branch line ($L_3$) when a fusion failure occurs in the first main switch SW1 and/or the precharge switch ($SW_{FC}$) according to an embodiment of the present disclosure.

The current $I_1$ represents the current flowing on the branch line ($L_3$) through the first precharge resistor 11 and the precharge switch ($SW_{FC}$) when a fusion failure occurs in the precharge switch ($SW_{FC}$). The current $I_2$ represents the current flowing on the branch line ($L_3$) through the first main switch SW1 and the second precharge resistor 12 when a fusion failure occurs in the first main switch SW1. The current $I_3$ represents the current flowing through the second precharge resistor 12 when the voltage ($V_{Load}$) of the load is greater than 0.

The magnitudes of the currents $I_1$, $I_2$ and $I_3$ may be determined by Equation 1 below according to Ohm's law.

$$\text{<Formula 1>}$$

$$I_1 = (V_{BAT})/(R_1 + R_{SW\_FC})$$

$$I_2 = (V_{BAT})/(R_2 + R_{SW1})$$

$$I_3 = (V_{Load})/(R_2)$$

In Formula 1, $R_1$ and $R_2$ are the first resistance value of the first precharge resistor 11 and the second resistance value of the second precharge resistor 12, respectively. $R_{SW\_FC}$ is the fusion resistance value measured at both ends of the precharge switch ($SW_{FC}$) when a fusion failure occurs in the precharge switch ($SW_{FC}$). $R_{SW1}$ is the fusion resistance value measured at both ends of the first main switch SW1 when a fusion failure occurs in the first main switch SW1. $R_1$ and $R_2$ may be known in advance from the specifications of the components, and $R_{SW\_FC}$ and $R_{SW1}$ are values that can be known in advance through experiments that intentionally fuse switch components.

The diagnosing current value ($I_{diag}$) may be approximately equal to the sum of the magnitudes of currents $I_1$, $I_2$ and $I_3$.

If the first precharge resistor 11 and the second precharge resistor 12 are made of the same resistor element and the first main switch SW1 and the precharge switch ($SW_{FC}$) are the same switch element, the first threshold current value ($I_{th1}$) may be determined by Formula 2 below.

$$\text{<Formula 2>}$$

$$I_{th1} = [(V_{BAT})/(R_1 + R_{SW\_FC@max})] + \triangle I = [(V_{BAT})/(R_2 + R_{SW1@max})] + \triangle I$$

The first threshold current value ($I_{th1}$) may be smaller than the magnitude of the current $I_1$ that flows when a fusion failure actually occurs in the precharge switch ($SW_{FC}$) or the magnitude of the current $I_2$ that flows when a fusion failure actually occurs in the first main switch SW1.

In Formula 2, $R_1$ and $R_2$ may be substantially the same, and $R_{SW\_FC@max}$ and $R_{SW1@max}$ may be substantially the same.

In Formula 2, $R_{SW\_FC@max}$ corresponds to a value that can be known in advance as the maximum resistance value of the precharge switch ($SW_{FC}$) that may be diagnosed as having a fusion failure in the precharge switch ($SW_{FC}$) (hereinafter, referred to as a fusion diagnosing resistance). When there is no fusion failure in the precharge switch ($SW_{FC}$), the resistance value $R_{SW\_FC}$ of the precharge switch ($SW_{FC}$) is very large, at the level of tens to hundreds of megaohms, so

the magnitude of $I_1$ is practically 0. As fusion slowly progresses between the contacts of the precharge switch ($SW_{FC}$), if the resistance value $R_{SW\_FC}$ of the precharge switch ($SW_{FC}$) is lowered below the fusion diagnosing resistance ($R_{SW\_FC@max}$), the magnitude of $I_1$ increases to several mA and may increase gradually as fusion progresses.

In Formula 2, $R_{SW1@max}$ corresponds to a value that can be known in advance as the maximum fusion resistance value (hereinafter, referred to as a fusion diagnosing resistance) of the first main switch SW1 that may be diagnosed as having a fusion failure in the first main switch SW1. When there is no fusion failure in the first main switch SW1, the resistance value $R_{SW1}$ of the first main switch SW1 is very large, at the level of tens to hundreds of megaohms, so the magnitude of $I_2$ is practically 0. As fusion slowly progresses between the contacts of the first main switch SW1, if the resistance value $R_{SW1}$ of the first main switch SW1 is lowered below fusion diagnosing resistance ($R_{SW1@max}$), the magnitude of $I_2$ increases to several mA and may gradually increase as fusion progresses.

$\triangle I$ is a current value set as a diagnosing margin, and may be set to an appropriate value considering the measurement error of the current measuring unit 20, the magnitude of current $I_3$, and the sensitivity of failure diagnosis.

$\triangle I$ may have a fixed value greater than or equal to 0 or a value varying depending on the voltage ($V_{Load}$) of the load.

In an embodiment, $\triangle I$ may be set in the range of 0 to hundreds of mA.

According to another aspect, if the condition that the diagnosing current value ($I_{diag}$) is greater than a preset second threshold current value $I_{th2}$ (greater than the first threshold current value $I_{th1}$) is met, the control unit 30 may diagnose that both the first main switch SW1 and the precharge switch ($SW_{FC}$) ) have a fusion failure.

The second threshold current value ($I_{th2}$) may be set in advance by Formula 3 below.

<Formula 3>

$$I_{th2} = [(V_{BAT})/(R_1 + R_{SW\_FC@max})] + [(V_{BAT})/(R_2 + R_{SW1@max})] + \triangle I$$

If the first precharge resistor 11 and the second precharge resistor 12 are the same resistor element and the first main switch SW1 and the precharge switch ($SW_{FC}$) are the same switch element, the second threshold current value ($I_{th2}$) may be set in advance by Formula 4 below.

<Formula 4>

$$I_{th2} = 2*[(V_{BAT})/(R_1 + R_{SW\_FC@max})] + \triangle I$$

$$= 2*[(V_{BAT})/(R_2 + R_{SW1@max})] + \triangle I$$

The second threshold current value ($I_{th2}$) may be smaller than the magnitude of the current that is the sum of the current $I_1$ that flows when a fusion failure actually occurs in the precharge switch ($SW_{FC}$) and the current $I_2$ that flows when a fusion failure actually occurs in the first main switch SW1.

In Formula 4, $R_1$ and $R_2$ may be substantially the same, and $R_{SW\_FC@max}$ and $R_{SW1@max}$ may be substantially the same.

$\triangle I$ is a current value set as a diagnosing margin, and may be set to an appropriate value considering the measurement error of the current measuring unit 20, the magnitude of current $I_3$, and the sensitivity of failure diagnosis.

$\triangle I$ may have a fixed value greater than or equal to 0 or a value varying depending on the voltage ($V_{Load}$) of the load.

In an embodiment, $\triangle I$ may be set in the range of 0 to hundreds of mA.

According to another modification, in order to increase the accuracy of fusion failure diagnosis, the first resistance value ($R_1$) of the first precharge resistor 11 and the second resistance value ($R_2$) of the second precharge resistor 12 may be different. In one example, the first resistance value ($R_1$) may be 1.5 to 2 times the second resistance value ($R_2$). Conversely, the second resistance value ($R_2$) may be 1.5 to 2 times the first resistance value ($R_2$).

In this modification, the first threshold current value ($I_{th1}$) may be set to be divided into two different values, namely a first sub-threshold current value ($I_{th1-1}$) and a second sub-threshold current value ($I_{th1-2}$) as shown in Formula 5 below.

<Formula 5>

$$I_{th1-1} = [(V_{BAT})/(R_1 + R_{SW\_FC@max})] + \triangle I$$

$$I_{th1-2} = [(V_{BAT})/(R_2 + R_{SW1@max})] + \triangle I$$

**In** an embodiment, the first sub-threshold current value ($I_{th1-1}$) may be smaller than the second sub-threshold current value ($I_{th1-2}$). However, it is obvious to those skilled in the art that the opposite case is also possible.

In Formula 5, when the precharge switch ($SW_{FC}$) and the first main switch SW1 are the same switch element, the fusion diagnosing resistance ($R_{SW\_FC@max}$) of the precharge switch ($SW_{FC}$) and the fusion diagnosing resistance ($R_{SW1@max}$) of the first main switch SW1 may be substantially the same.

$\triangle I$ is a current value set as a diagnosing margin, and may be set to an appropriate value considering the measurement error of the current measuring unit 20, the magnitude of current $I_3$, and the sensitivity of failure diagnosis.

$\triangle I$ may have a fixed value greater than or equal to 0 or a value varying depending on the voltage ($V_{Load}$) of the load.

In an embodiment, $\triangle I$ may be set in the range of 0 to hundreds of mA.

According to a modification, the first resistance value ($R_1$) may be greater than the second resistance value ($R_2$), and the first sub-threshold current value ($I_{th1-1}$) may be smaller than the second sub-threshold current value ($I_{th1-2}$). In this case, if the diagnosing current value ($I_{diag}$) measured when the diagnosing switch ($SW_{diag}$) is turned on is greater than the first sub-threshold current value ($I_{th1-1}$) and is equal to or smaller than the second sub-threshold current value ($I_{th1-2}$), the control unit 30 may diagnose that a fusion failure has occurred in the precharge switch ($SW_{FC}$). In addition, if the magnitude of the diagnosing current value ($I_{diag}$) is greater than the second sub-threshold current value ($I_{th1-2}$) and is equal to or smaller than the second threshold current value ($I_{th2}$), the control unit 30 may diagnose that a fusion failure has occurred in the first main switch SW1. Also, if the diagnosing current value ($I_{diag}$) is greater than the second threshold current value ($I_{th2}$), the control unit 30 may diagnose that a fusion failure has occurred in both the first main switch SW1 and the precharge switch ($SW_{FC}$).

According to another modification, the second resistance value ($R_2$) may be greater than the first resistance value ($R_1$), and the second sub-threshold current value ($I_{th1-2}$) may be smaller than the first sub-threshold current value $I_{th1-1}$. In this case, if the magnitude of the diagnosing current value ($I_{diag}$) measured when the diagnosing switch ($SW_{diag}$) is turned on is greater than the second sub-threshold current value ($I_{th1-2}$) and is equal to or smaller than the first sub-threshold current value ($I_{th1-1}$), the control unit 30 may diagnose that a fusion failure has occurred in the first main switch SW1. Also, if the magnitude of the diagnosing current value ($I_{diag}$) is greater than the first sub-threshold current value ($I_{th1-1}$) and is equal to as or smaller than the second threshold current value ($I_{th2}$), the control unit 30 may diagnose that a fusion failure has occurred in the precharge switch ($SW_{FC}$). Also, if the magnitude of the diagnosing current value ($I_{diag}$) is greater than the second threshold current value ($I_{th2}$), the control unit 30 may diagnose that a fusion failure has occurred in both the first main switch SW1 and the precharge switch ($SW_{FC}$).

In another aspect, the battery managing apparatus 100 may further include a storage medium 60. The control unit 30 may be operably coupled with the storage medium 60. The storage medium 60 is not limited as being included inside the control unit 30. The storage medium 60 may store data and programs required for calculation operations by the control unit 30. The control unit 60 may cumulatively store data representing the result of calculation operation, for example a failure diagnosing result of a switch, along with a time stamp in the storage medium 60. The failure diagnosing result of the switch may include identification information of the switch in which a fusion failure has occurred among the first main switch SW1 and the precharge switch ($SW_{FC}$).

The control unit 30 is a control circuit and may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing the other functions.

The storage medium 60 may be, for example, at least one type of storage medium among flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM).

According to another aspect, the battery managing apparatus 100 may further include an output device 70. The control unit 30 may be operably coupled with the output device 70. The output device 70 may be a display that visually displays information. The control unit 30 may read the failure diagnosing result of the switch from the storage medium 60 and visually output the failure diagnosing result through the output device 70. The output device 70 may be provided in the load L that receives power from the battery B. For example, when the load L is an electric vehicle, the output device 70 may be an integrated information display of the electric vehicle.

According to another aspect, the battery managing apparatus 100 may further include a communication interface 80. The control unit 30 may be operably coupled with the communication interface 80. The control unit 30 may read the failure diagnosing result of the switch from the storage medium 60 and transmit the failure diagnosing result to the outside through the communication interface 80.

The communication interface 80 may include a communication circuit configured to support wired communication and/or wireless communication between the control unit 30 and an external device. Wired communication may be, for example, CAN (Controller Area Network) communication, and wireless communication may be mobile communication such as 4G or 5G, or short-distance communication such as Wi-Fi, ZigBee, or Bluetooth. Any type of communication protocol may be adopted as long as it supports wired or wireless communication between the control unit 30 and an external device.

In one example, an external device may be provided in the load L. When the load L is an electric vehicle, the external device may be an integrated control system of the electric vehicle. The integrated control system may output a warning message through the integrated information display of the electric vehicle when the failure diagnosing result of the switch transmitted from the control unit 30 indicates that a fusion failure has occurred in the first main switch and/or the precharge switch.

In another example, the external device may be a remote server computer. If the failure diagnosing result of the switch transmitted from control unit 30 indicates that a fusion failure has occurred in the first main switch and/or the precharge switch, the remote server computer may send a warn message indicating that the battery B needs to be inspected using a program installed on a mobile phone terminal of the driver.

In another example, the external device may be an on-board diagnosing device connected through the communication interface 80. The on-board diagnosing device is a device that checks the status of various components included in an electric vehicle. When the on-board diagnosing device is connected through the communication interface 80, the control unit 30 may read the failure diagnosing result of the switch stored in the storage medium 60 and transmit the failure diagnosing result to the on-board diagnosing device through the communication interface 80. Then, the operator may recognize the failure diagnosing result of the switch output through the display of the on-board diagnosing device and perform a detailed inspection on the first main switch SW1 and/or the precharge switch ($SW_{FC}$) of the battery B.

In the present disclosure, the control unit 30 may optionally include a processor, an application-specific integrated circuit (ASIC), other chipsets, logic circuits, registers, communication modems, data processing devices, etc. known in the art to execute the various control logics described above.

Also, when the control logics are implemented as software, the control unit 25 may be a processor that executes a set of program modules. At this time, the program module may be stored in a memory and executed by the processor. The memory may be provided inside or outside the processor, and may be connected to the processor by various well-known computer components. Also, the memory may be included in the storage medium 26. Also, the memory generically refers to a device that stores information regardless of the type of device, and does not refer to a specific memory device.

In addition, one or more of the various control logics of the control unit 30 are combined, and the combined control logics may be written in a computer-readable code system and recorded on a computer-readable storage medium. The type of the storage medium is not particularly limited as long as it can be accessed by a processor included in a computer. As an example, the storage medium includes at least one selected from the group including a ROM, a RAM, a register, a CD-ROM, a magnetic tape, a hard disk, a floppy disk, and an optical data recording device. In addition, the code system may be distributed and stored and executed in computers connected through a network. In addition, functional programs, codes and code segments for implementing the combined control logics may be easily inferred by programmers in the art to which the present disclosure belongs.

The battery managing apparatus 100 according to an embodiment of the present disclosure may be included in a battery management system that is called BMS in the art. Also, the battery managing apparatus 100 may be included in a battery diagnosing system. In addition, the battery managing apparatus 100 may be included in various systems in which the battery B is mounted. Also, the system including the battery managing apparatus 100 may be included in a vehicle. The vehicle may be a two-wheeled, three-wheeled or four-wheeled vehicle. The vehicle may include a motor mechanism driven by power supplied from the battery B.

Hereinafter, a battery managing method having a switch failure diagnosing function according to an embodiment of the present disclosure described above will be described in detail.

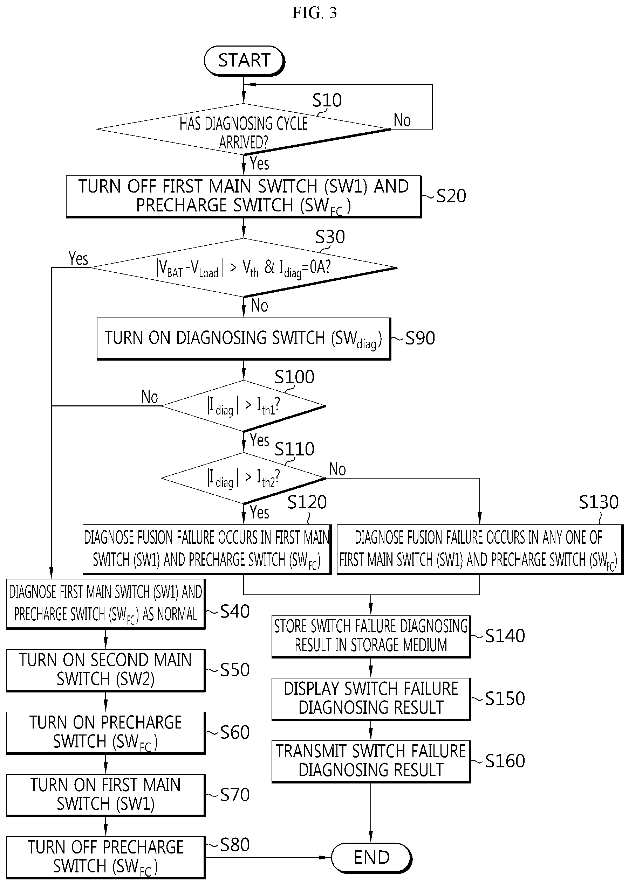

FIG. 3 is a flowchart for illustrating a battery managing method having a switch failure diagnosing function according to an embodiment of the present disclosure. The steps in FIG. 3 may be executed by the control unit 30 before charging or discharging of the battery B begins.

Referring to FIG. 3, first, in Step S10, the control unit 30 determines whether a failure diagnosing cycle of a switch has arrived. Preferably, the failure of the switch may be diagnosed before charging or discharging of the battery B starts.

If the determination in Step S10 is NO, the process progress is held.

If the determination in Step S10 is YES, in Step S20, the control unit 30 turns off the first main switch SW1 and the precharge switch ($SW_{FC}$). Optionally, the control unit 30 may also turn off the second main switch SW2 together with the first main switch SW1 in Step S20. Step S30 proceeds after Step S20.

In Step S30, the control unit 30 receives the battery voltage ($V_{BAT}$) from the first voltage measuring unit 40, receives the load voltage ($V_{Load}$) from the second voltage measuring unit 40, and receives the diagnosing current value ($I_{diag}$) flowing through the sense resistor (Rs) from the current measuring unit 20. Also, the control unit 30 determines whether the difference between the battery voltage ($V_{BAT}$) and the voltage ($V_{Load}$) of the load is greater than a threshold voltage value ($V_{th}$) and the diagnosing current value ($I_{diag}$) is substantially 0.

If the determination in Step S30 is YES, the control unit 30 diagnoses the first main switch SW1 and the precharge switch ($SW_{FC}$) as normal in Step S40. Here, the normal state means a state in which there is no fusion failure. In addition, in order to start charging or discharging the battery B, the control unit 30 turns on the second main switch SW2 in Step 50, turns on the precharge switch ($SW_{FC}$) in Step S60, turns on the first main switch SW1 in Step S70, and turns off the precharge switch ($SW_{FC}$) in Step S80. Between the turn-on point of the precharge switch ($SW_{FC}$) and the turn-on point of the first main switch SW1, a time gap is set such that the capacitor on the load L connected in parallel with the battery B may be sufficiently charged. After Step S80, the diagnosis of the switch is completed and charging or discharging of the battery B may begin.

If the determination in Step S30 is NO, the process to diagnose a fusion failure of the first main switch SW1 and the precharge switch ($SW_{FC}$) begins.

Specifically, in Step S90, the control unit 30 turns on the diagnosing switch ($SW_{diag}$) of the branch line ($L_3$). Subsequently, in Step S100, the control unit 30 receives the diagnosing current value ($I_{diag}$) flowing through the sense resistor (Rs) through the current measuring unit 20 and determines whether the magnitude of the diagnosing current value ($I_{diag}$) is greater than a preset first threshold current value ($I_{th1}$).

In an embodiment, if the first precharge resistor 11 and the second precharge resistor 12 are made of the same resistor element and the types of the first main switch SW1 and the precharge switch ($SW_{FC}$) are the same, the first threshold current value ($I_{th1}$) may be set in advance as a current value determined by Formula 2 and recorded in advance on the storage medium 60.

If the determination in Step S100 is NO, the control unit 30 performs Steps S40 to S80.

Meanwhile, if the determination in Step S 100 is YES, in Step S110, the control unit 30 determines whether the magnitude of the diagnosing current value ($I_{diag}$) is greater than a preset second threshold current value ($I_{th2}$).

In an embodiment, if the first precharge resistor 11 and the second precharge resistor 12 are the same resistor element and the first main switch SW1 and the precharge switch ($SW_{FC}$) are the same switch element, the second threshold current value ($I_{th2}$) may be set in advance as a current value determined by Equation 4 and recorded in advance on the storage medium 60.

If the determination in Step S110 is YES, the magnitude of the diagnosing current value ($I_{diag}$) is relatively larger than the second threshold current value ($I_{th2}$). In this case, in Step S120, the control unit 30 may diagnose that a fusion failure has occurred in both the first main switch SW1 and the precharge switch ($SW_{FC}$). Meanwhile, if the determination in Step S110 is NO, the magnitude of the diagnosing current value ($I_{diag}$) is greater than the first threshold current value ($I_{th1}$) and equal to or smaller than the second threshold current value ($I_{th2}$). In this case, in Step S130, the control unit 30 may diagnose that a fusion failure has occurred in any one of the first main switch SW1 and the precharge switch ($SW_{FC}$).

After Steps S120 and S130, Step S140 proceeds.

In Step S140, the control unit 30 may record the switch failure diagnosing result in the storage medium 60. The switch failure diagnosing result may include identification information of the switch in which a fusion failure has occurred. In Step S150, the control unit 30 may also read the switch failure diagnosing result recorded in the storage medium 60 and display the switch failure diagnosing result visually through the output device 70. In Step S160, the control unit 30 may also read the switch failure diagnosing result recorded in the storage medium 60 and transmit the switch failure diagnosing result to an external device through the communication interface 80. If Step S160 is performed, the process of the battery managing method according to an embodiment of the present disclosure is completed. Meanwhile, Step S150 and/or Step S160 are optional steps and may be omitted.

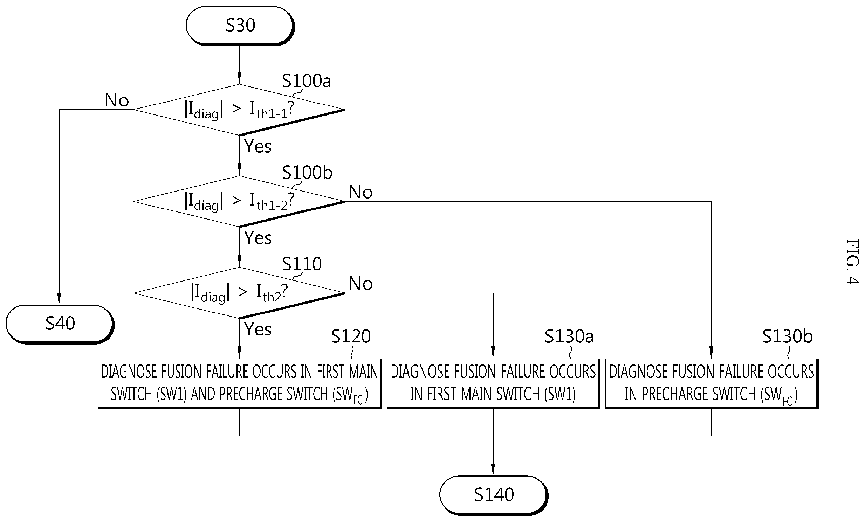

FIG. 4 is a flowchart for illustrating a battery managing method having a switch failure diagnosing function according to another embodiment of the present disclosure. Another embodiment of the present disclosure is characterized in that Step S100 of FIG. 3 is modified compared to the former embodiment.

Referring to FIG. 4, Step S100a proceeds after Step S90. That is, the control unit 30 turns on the diagnosing switch ($SW_{diag}$), then receives the diagnosing current value ($I_{diag}$) flowing through the sense resistor (Rs) from the current measuring unit 20 in Step S100a, and determines whether the magnitude of the diagnosing current value ($I_{diag}$) is greater than the first sub-threshold current value ($I_{th1-1}$). The first sub-threshold current value ($I_{th1-1}$) may be set to a value determined by Formula 5 and may be recorded in advance on the storage medium 60.

If the determination in Step S100a is NO, the control unit 30 may proceed to Step S40 of FIG. 3 and execute Steps S40 to S80 in substantially the same way as the former embodiment.

Meanwhile, if the determination in Step S100a is YES, in Step S100b, the control unit 30 determines whether the magnitude of the diagnosing current value ($I_{diag}$) is greater than the second sub-threshold current value ($I_{th1-2}$). The second sub-threshold current value ($I_{th1-2}$) may be set to a value greater than the first sub-threshold current value ($I_{th1-1}$) and determined by Formula 5, and may be recorded in advance on the storage medium 60.

If the determination in Step S100b is NO, the magnitude of the diagnosing current value ($I_{diag}$) is greater than the first sub-threshold current value ($I_{th1-1}$) and is equal to or smaller than the second sub-threshold current value ($I_{th1-2}$). In this case, in Step S130b, the control unit 30 may diagnose that a fusion failure has occurred in the precharge switch ($SW_{FC}$).

If the determination in Step S100b is YES, in Step S110, the control unit 30 determines whether the magnitude of the diagnosing current value ($I_{diag}$) is greater than the second threshold current value ($I_{th2}$). The second threshold current value ($I_{th2}$) may be set to a value determined by Formula 4 and may be recorded in advance on the storage medium 60.

If the determination in Step S110 is NO, the magnitude of the diagnosing current value ($I_{diag}$) is greater than the second sub-threshold current value ($I_{th1-2}$) and is equal to or smaller than the second threshold current value ($I_{th2}$). In this case, in Step S130a, the control unit 30 may diagnose that a fusion failure has occurred in the first main switch SW1.

Meanwhile, if the determination in Step S110 is YES, the magnitude of the diagnosing current value ($I_{diag}$) is greater than the second threshold current value ($I_{th2}$). In this case, in Step S120, the control unit 30 may diagnose that a fusion failure has occurred in both the first main switch SW1 and the precharge switch ($SW_{FC}$).

After Steps S120, S130a, and S130b, the control unit 30 may perform Steps S140 to S160 of FIG. 3 in substantially the same manner as the former embodiment.

Meanwhile, in a modification, the second sub-threshold current value ($I_{th1-2}$) may be smaller than the first sub-threshold current value ($I_{th1-1}$). In this case, Step S100b may be executed first, followed by Step S100a. Also, if the determination in Step S100b is NO, Steps S40 to S80 may proceed. Also, if the determination in Step S100a is NO, it is possible to diagnose that a fusion failure has occurred in the first main switch SW1. Also, when the determination in Step S110 is NO, it is possible to diagnose that a fusion failure has occurred in the precharge switch ($SW_{FC}$).

According to the present disclosure, it is possible to reliably diagnose a fusion failure of the main switch and/or the precharge switch installed on the high potential line of the battery by installing a precharge circuit 10 in which a first precharge resistor, a precharge switch and a second precharge resistor are sequentially connected in series, and a diagnosing switch on a branch line connecting one end of the precharge switch and the low potential line of the battery, and analyzing the magnitude of the diagnosing current value measured immediately after the diagnosing switch is turned on.

In describing various embodiments of the present disclosure, elements named '... unit' should be understood as functionally distinct elements rather than physically distinct elements. Thus, each component may be selectively integrated with other components or each component may be divided into sub-components for efficient execution of control logics. However, it is obvious to those skilled in the art that even if the components are integrated or divided, if the same function can be recognized, the integrated or divided components should also be interpreted as falling within the scope of the present disclosure.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, as many substitutions, modifications and changes may be made to the present disclosure described hereinabove by those skilled in the art without departing from the technical aspects of the present disclosure, the present disclosure is not limited by the above-described embodiments and the accompanying drawings, and all or some of the embodiments may be selectively combined to allow various modifications.

**Claims**

1. A battery managing apparatus having a switch failure diagnosing function, comprising:

    a main switch installed on a first line connected to one terminal of a battery;
    a precharge circuit including a first precharge resistor, a precharge switch, and a second precharge resistor sequentially connected in series, the precharge circuit being connected in parallel with both ends of the main switch;
    a current measuring unit configured to measure current flowing through a second line connected to the other terminal of the battery;
    a diagnosing switch installed on a branch line that connects one end of the precharge switch and the second line; and
    a control unit operably coupled with the main switch, the precharge switch, the diagnosing switch and the current measuring unit,

wherein the control unit is configured to receive a diagnosing current value from the current measuring unit when the diagnosing switch is turned on or off, and diagnose whether at least one of the main switch and the precharge switch has a fusion failure based on a magnitude of the diagnosing current value.

2. The battery managing apparatus having a switch failure diagnosing function according to claim 1, further comprising:

a first voltage measuring unit configured to measure a battery voltage between a first terminal and a second terminal of the battery; and
a second voltage measuring unit configured to measure a voltage of a load between a first connection terminal and a second connection terminal of the load,
wherein the control unit is configured to:

receive the battery voltage and the voltage of the load from the first voltage measuring unit and the second voltage measuring unit, respectively, and receive the diagnosing current value from the current measuring unit, when the main switch and the precharge switch are turned off, and
diagnose that there is no fusion failure in the main switch and the precharge switch when a difference between the battery voltage and the voltage of the load is greater than a preset threshold voltage value and the diagnosing current value is substantially 0.

3. The battery managing apparatus having a switch failure diagnosing function according to claim 2,
wherein the control unit is optionally configured to:

turn on the diagnosing switch and then receive the diagnosing current value from the current measuring unit when the difference between the battery voltage and the voltage of the load is substantially 0 and the diagnosing current value is substantially 0, and
diagnose that a fusion failure has occurred in any one of the main switch and the precharge switch when the diagnosing current value is greater than a preset first threshold current value.

4. The battery managing apparatus having a switch failure diagnosing function according to claim 3,
wherein the control unit is optionally configured to diagnose that the main switch and the precharge switch have the fusion failure when the diagnosing current value is greater than a preset second threshold current value, wherein the preset second threshold current value is greater than the first threshold current value.

5. The battery managing apparatus having a switch failure diagnosing function according to claim 4,

wherein the first precharge resistor and the second precharge resistor have a first resistance value and a second resistance value, respectively, where the first resistance value is greater than the second resistance value,
wherein the first threshold current value is divided into a first sub-threshold current value determined by Ohm's law from the first resistance value, a fusion diagnosing resistance of the precharge switch and the battery voltage, and a second sub-threshold current value, which is greater than the first sub-threshold current value, determined by Ohm's law from the second resistance value, a fusion diagnosing resistance of the main switch and the battery voltage,
wherein the control unit is optionally configured to:

diagnose that the fusion failure has occurred in the precharge switch when the diagnosing current value is greater than the first sub-threshold current value and is equal to or smaller than the second sub-threshold current value,
diagnose that the fusion failure has occurred in the main switch when the diagnosing current value is greater than the second sub-threshold current value and is equal to or smaller than the second threshold current value, and
diagnose that a fusion failure has occurred in both the main switch and the precharge switch when the diagnosing current value is greater than the second threshold current value.

6. The battery managing apparatus having a switch failure diagnosing function according to claim 4,

wherein the first precharge resistor and the second precharge resistor have a first resistance value and a second resistance value, respectively, where the second resistance value is greater than the first resistance value,
wherein the first threshold current value is divided into a first sub-threshold current value determined by Ohm's law from the first resistance value, a fusion diagnosing resistance of the precharge switch and the battery voltage, and a second sub-threshold current value, which is smaller than the first sub-threshold current value, determined by Ohm's law from the second resistance value, a fusion diagnosing resistance of the main switch and the battery voltage,

wherein the control unit is optionally configured to:

diagnose that a fusion failure has occurred in the main switch when the diagnosing current value is greater than the second sub-threshold current value and is equal to or smaller than the first sub-threshold current value,

diagnose that the fusion failure has occurred in the precharge switch when the diagnosing current value is greater than the first sub-threshold current value and is equal to or smaller than the second threshold current value, and

diagnose that the fusion failure has occurred in both the main switch and the precharge switch when the diagnosing current value is greater than the second threshold current value.

7. The battery managing apparatus having a switch failure diagnosing function according to claim 1, further comprising:

a storage medium operably coupled with the control unit,
wherein the control unit is configured to record a failure diagnosing result for the main switch and the precharge switch on the storage medium.

8. The battery managing apparatus having a switch failure diagnosing function according to claim 7, further comprising:

an output device operably coupled with the control unit,
wherein the control unit is configured to read the failure diagnosing result from the storage medium and output the failure diagnosing result visually through the output device.

9. The battery managing apparatus having a switch failure diagnosing function according to claim 7, further comprising:

a communication interface operably coupled with the control unit,
wherein the control unit is configured to read the failure diagnosing result from the storage medium and transmit the failure diagnosing result to the outside through the communication interface.

10. A system, comprising the battery managing apparatus according to any one of claims 1 to 9.

11. A vehicle, comprising the system according to claim 10.

12. A battery managing method having a switch failure diagnosing function using a main switch installed on a first line connected to one terminal of a battery; a precharge circuit including a first precharge resistor, a precharge switch, and a second precharge resistor sequentially connected in series, the precharge circuit being connected in parallel with both ends of the main switch; a current measuring unit configured to measure current flowing through a second line connected to the other terminal of the battery; and a diagnosing switch installed on a branch line that connects one end of the precharge switch and the second line, the battery managing method comprising:

(a) receiving a diagnosing current value from the current measuring unit when the diagnosing switch is turned on or off; and
(b) diagnosing whether at least one of the main switch and the precharge switch has a fusion failure based on a magnitude of the diagnosing current value.

13. The battery managing method according to claim 12, further comprising:

measuring a battery voltage between a first terminal and a second terminal of the battery and a voltage of a load between a first connection terminal and a second connection terminal of the load when the main switch and the precharge switch are turned off,
wherein in the step (b), optionally, it is diagnosed that there is no fusion failure in the main switch and the precharge switch when a difference between the battery voltage and the voltage of the load is greater than a preset threshold voltage value and the diagnosing current value is substantially 0.

**14.** The battery managing method according to claim 12, further comprising:

measuring a battery voltage between a first terminal and a second terminal of the battery and a voltage of a load between a first connection terminal and a second connection terminal of the load when the main switch and the precharge switch are turned off,

wherein in the step (a), the diagnosing switch is turned on and then the diagnosing current value is received from the current measuring unit when a difference between the battery voltage and the voltage of the load is substantially 0 and the diagnosing current value is substantially 0, and

wherein in the step (b), it is diagnosed that the fusion failure has occurred in any one of the main switch and the precharge switch when the diagnosing current value is greater than a preset first threshold current value.

**15.** The battery managing method according to claim 12, further comprising:

measuring a battery voltage between a first terminal and a second terminal of the battery and a voltage of a load between a first connection terminal and a second connection terminal of the load when the main switch and the precharge switch are turned off,

wherein in the step (a), the diagnosing switch is turned on and then the diagnosing current value is received from the current measuring unit when a difference between the battery voltage and the voltage of the load is substantially 0 and the diagnosing current value is substantially 0, and

wherein in the step (b), it is diagnosed that both the main switch and the precharge switch have a fusion failure when the diagnosing current value is greater than a preset second threshold current value, wherein the preset second threshold current value is greater than the first threshold current value.

**16.** The battery managing method according to claim 14,

wherein the first precharge resistor and the second precharge resistor have a first resistance value and a second resistance value, respectively, where the first resistance value is greater than the second resistance value,

wherein the first threshold current value is divided into a first sub-threshold current value determined by Ohm's law from the first resistance value, a fusion diagnosing resistance of the precharge switch and the battery voltage, and a second sub-threshold current value, which is greater than the first sub-threshold current value, determined by Ohm's law from the second resistance value, a fusion diagnosing resistance of the main switch and the battery voltage, and

wherein in the step (b), it is diagnosed that the fusion failure has occurred in the precharge switch when the diagnosing current value is greater than the first sub-threshold current value and is equal to or smaller than the second sub-threshold current value,

it is diagnosed that the fusion failure has occurred in the main switch when the diagnosing current value is greater than the second sub-threshold current value and is equal to or smaller than the second threshold current value, and

it is diagnosed that the fusion failure has occurred in both the main switch and the precharge switch when the diagnosing current value is greater than the second threshold current value.

**17.** The battery managing method according to claim 14,

wherein the first precharge resistor and the second precharge resistor have a first resistance value and a second resistance value, respectively, where the second resistance value is greater than the first resistance value,

wherein the first threshold current value is divided into a first sub-threshold current value determined by Ohm's law from the first resistance value, a fusion diagnosing resistance of the precharge switch and the battery voltage, and a second sub-threshold current value, which is smaller than the first sub-threshold current value, determined by Ohm's law from the second resistance value, a fusion diagnosing resistance of the main switch and the battery voltage, and

wherein in the step (b), it is diagnosed that the fusion failure has occurred in the main switch when the diagnosing current value is greater than the second sub-threshold current value and is equal to or smaller than the first sub-threshold current value,

it is diagnosed that the fusion failure has occurred in the precharge switch when the diagnosing current value is greater than the first sub-threshold current value and is equal to or smaller than the second threshold current value, and

it is diagnosed that the fusion failure has occurred in both the main switch and the precharge switch when the diagnosing current value is greater than the second threshold current value.

**18.** The battery managing method according to claim 12, further comprising:
recording a failure diagnosing result for the main switch and the precharge switch on a storage medium.

**19.** The battery managing method according to claim 18, further comprising:
reading the failure diagnosing result from the storage medium and output the failure diagnosing result visually through an output device.

**20.** The battery managing method according to claim 18, further comprising:
reading the failure diagnosing result from the storage medium and transmit the failure diagnosing result to the outside through a communication interface.

FIG. 1

FIG. 2

FIG. 3

START

S10 — HAS DIAGNOSING CYCLE ARRIVED? — No / Yes

S20 — TURN OFF FIRST MAIN SWITCH (SW1) AND PRECHARGE SWITCH (SW$_{FC}$)

S30 — $|V_{BAT} - V_{Load}| > V_{th}$ & $I_{diag} = 0A$? — Yes / No

S90 — TURN ON DIAGNOSING SWITCH (SW$_{diag}$)

S100 — $|I_{diag}| > I_{th1}$? — No / Yes

S110 — $|I_{diag}| > I_{th2}$? — No / Yes

S120 — DIAGNOSE FUSION FAILURE OCCURS IN FIRST MAIN SWITCH (SW1) AND PRECHARGE SWITCH (SW$_{FC}$)

S130 — DIAGNOSE FUSION FAILURE OCCURS IN ANY ONE OF FIRST MAIN SWITCH (SW1) AND PRECHARGE SWITCH (SW$_{FC}$)

S40 — DIAGNOSE FIRST MAIN SWITCH (SW1) AND PRECHARGE SWITCH (SW$_{FC}$) AS NORMAL

S50 — TURN ON SECOND MAIN SWITCH (SW2)

S60 — TURN ON PRECHARGE SWITCH (SW$_{FC}$)

S70 — TURN ON FIRST MAIN SWITCH (SW1)

S80 — TURN OFF PRECHARGE SWITCH (SW$_{FC}$)

S140 — STORE SWITCH FAILURE DIAGNOSING RESULT IN STORAGE MEDIUM

S150 — DISPLAY SWITCH FAILURE DIAGNOSING RESULT

S160 — TRANSMIT SWITCH FAILURE DIAGNOSING RESULT

END

FIG. 4

## INTERNATIONAL SEARCH REPORT

| | International application No. |
|---|---|
| | **PCT/KR2024/001852** |

| A. | CLASSIFICATION OF SUBJECT MATTER |
|---|---|
| | **G01R 31/327**(2006.01)i; **G01R 19/165**(2006.01)i; **G01R 31/385**(2019.01)i; **G01R 27/02**(2006.01)i; **G08C 17/02**(2006.01)i |

According to International Patent Classification (IPC) or to both national classification and IPC

| B. | FIELDS SEARCHED |
|---|---|

Minimum documentation searched (classification system followed by classification symbols)

G01R 31/327(2006.01); B60L 3/00(2006.01); B60L 9/18(2006.01); G01R 19/00(2006.01); G01R 19/165(2006.01); G01R 31/36(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 메인 스위치(main switch), 프리차지 회로(precharge circuit), 전류 측정부(current measuring part), 진단 스위치(diagnostic switch), 전압 측정부(voltage measuring part), 융착 고장 (fusion failure)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2017-0098049 A (LG CHEM, LTD.) 29 August 2017 (2017-08-29)<br>See paragraphs [0062]-[0104], claims 1, 7-8 and 13 and figures 1-5. | 1-4,7-15,18-20 |
| A | | 5-6,16-17 |
| Y | JP 2009-089535 A (SANYO ELECTRIC CO., LTD.) 23 April 2009 (2009-04-23)<br>See paragraphs [0028]-[0030] and figure 1. | 1-4,7-15,18-20 |
| A | KR 10-2021-0066035 A (SK INNOVATION CO., LTD.) 07 June 2021 (2021-06-07)<br>See claim 1 and figures 1-5. | 1-20 |
| A | KR 10-2022-0045435 A (LG ENERGY SOLUTION, LTD.) 12 April 2022 (2022-04-12)<br>See claim 1 and figure 1. | 1-20 |

| ✓ Further documents are listed in the continuation of Box C. | ✓ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **10 May 2024** | **13 May 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**EP 4 636 415 A1**

**INTERNATIONAL SEARCH REPORT**

International application No.

**PCT/KR2024/001852**

| C. | DOCUMENTS CONSIDERED TO BE RELEVANT | |
|---|---|---|
| Category* | Citation of document, with indication, where appropriate, of the relevant passages | Relevant to claim No. |
| A | KR 10-2014-0020765 A (GS YUASA INTERNATIONAL LTD.) 19 February 2014 (2014-02-19) See claim 1 and figure 1. | 1-20 |

Form PCT/ISA/210 (second sheet) (July 2022)

22

## INTERNATIONAL SEARCH REPORT
### Information on patent family members

| International application No. |
| --- |
| **PCT/KR2024/001852** |

| Patent document cited in search report | | | Publication date (day/month/year) | Patent family member(s) | | | Publication date (day/month/year) |
| --- | --- | --- | --- | --- | --- | --- | --- |
| KR | 10-2017-0098049 | A | 29 August 2017 | CN | 107850643 | A | 27 March 2018 |
| | | | | CN | 107850643 | B | 21 February 2020 |
| | | | | EP | 3324196 | A1 | 23 May 2018 |
| | | | | JP | 2018-536855 | A | 13 December 2018 |
| | | | | JP | 6671475 | B2 | 25 March 2020 |
| | | | | KR | 10-2059076 | B1 | 11 February 2020 |
| | | | | US | 10782350 | B2 | 22 September 2020 |
| | | | | US | 2018-0188326 | A1 | 05 July 2018 |
| | | | | WO | 2017-142385 | A1 | 24 August 2017 |
| JP | 2009-089535 | A | 23 April 2009 | JP | 5127387 | B2 | 23 January 2013 |
| KR | 10-2021-0066035 | A | 07 June 2021 | None | | | |
| KR | 10-2022-0045435 | A | 12 April 2022 | None | | | |
| KR | 10-2014-0020765 | A | 19 February 2014 | CN | 103580002 | A | 12 February 2014 |
| | | | | CN | 103580002 | B | 28 August 2018 |
| | | | | CN | 109085496 | A | 25 December 2018 |
| | | | | CN | 109085496 | B | 03 November 2020 |
| | | | | EP | 2696502 | A2 | 12 February 2014 |
| | | | | EP | 2696502 | A3 | 13 December 2017 |
| | | | | EP | 2696502 | B1 | 01 April 2020 |
| | | | | EP | 3687067 | A1 | 29 July 2020 |
| | | | | EP | 3687067 | B1 | 12 April 2023 |
| | | | | JP | 2014-036556 | A | 24 February 2014 |
| | | | | JP | 2016-192897 | A | 10 November 2016 |
| | | | | JP | 5983171 | B2 | 31 August 2016 |
| | | | | JP | 6233469 | B2 | 22 November 2017 |
| | | | | KR | 10-2047556 | B1 | 21 November 2019 |
| | | | | US | 2013-0320986 | A1 | 05 December 2013 |
| | | | | US | 2014-0176140 | A9 | 26 June 2014 |
| | | | | US | 2016-0084908 | A1 | 24 March 2016 |
| | | | | US | 9267992 | B2 | 23 February 2016 |
| | | | | US | 9746522 | B2 | 29 August 2017 |

Form PCT/ISA/210 (patent family annex) (July 2022)

**REFERENCES CITED IN THE DESCRIPTION**

**Patent documents cited in the description**

- KR 1020230019003